# EUROPEAN PATENT SPECIFICATION

(11) **EP 3 022 898 B1**
(45) Date of publication and mention of the grant of the patent: **15.04.2020**
(21) Application number: 14772236.7
(22) Date of filing: 18.07.2014
(51) Int. Cl.: H01L 27/146, H04N 5/33, H04N 5/369, H04N 5/225, H04N 9/09

(54) **ASYMMETRIC SENSOR ARRAY FOR CAPTURING IMAGES**
ASYMMETRISCHES BILDSENSORARRAY
CAPTEUR D'IMAGES ASYMMETRIQUE

(30) Priority: 19.07.2013 US 201361856449 P
(43) Date of publication of application: 25.05.2016
(73) Proprietor: Google Technology Holdings LLC, Mountain View, CA 94043 (US)
(72) Inventor: STETSON, Philip, Sean, Mountain View, CA 94043 (US); NEIFELD, Mark, A., Mountain View, CA 94043 (US); MUSATENKO, Yuriy, Mountain View, CA 94043 (US)
(74) Representative: Maikowski & Ninnemann Patentanwälte Partnerschaft mbB
(86) International application number: PCT/US2014/047313
(87) International publication number: WO 2015/010098

(56) References cited:
- EP-A1- 1 978 740
- EP-A1- 2 388 987
- EP-A2- 2 451 150
- EP-A2- 2 472 581
- WO-A2-2009/151903
- US-A1- 2005 134 712
- US-A1- 2008 151 084
- US-B1- 7 507 944
- HONG HUAM ET AL: "Dual-sensor foveated imaging system", APPLIED OPTICS, OPTICAL SOCIETY OF AMERICA, WASHINGTON, DC; US, vol. 47, no. 3, 20 January 2008 (2008-01-20), pages 317-327, XP001511036, ISSN: 0003-6935, DOI: 10.1364/AO.47.000317

## Description

### BACKGROUND

This background description is provided for the purpose of generally presenting the context of the disclosure. Unless otherwise indicated herein, material described in this section is neither expressly nor impliedly admitted to be prior art to the present disclosure or the appended claims.

Current sensor arrays for capturing images have partially addressed the need for a small form factor in the Z dimension for cameras and other imaging devices. These conventional sensor arrays, however, have various limitations. First, images captured for each sensor of the array must be combined in some manner through computational effort to construct the final image, which has varied success and requires computing resources. Second, this construction of the final image can be scene-dependent, meaning that some scenes result in relatively poor image quality. Third, these conventional sensor arrays often struggle to provide high resolution images, especially if there are any flaws in the sensors or lenses.
EP 2 472 581 A2 discloses an apparatus for combining a mobile communication device with a camera that includes a curved sensor. The apparatus comprises mobile communication means including an enclosure and an objective lens. The objective lens is mounted on said enclosure and arranged to collect a stream of radiation. A curved sensor includes a plurality of sensor elements, where the curved sensor is mounted inside said enclosure and aligned with the objective lens. The curved sensor has a portion which extends beyond a generally two-dimensional plane and has an output for recording an image. The combination of a mobile communication device with a camera that utilizes a curved sensor offers higher quality pictures than conventional phones that incorporate a flat sensor.
US 2005/134712 A1 discloses a color image sensor having imaging element array forming images on respective regions of sensor elements. The color image sensor generates a color image signal representing a subject and includes an optical substrate and a light sensor. The optical substrate includes spatially-separated imaging elements. Each of the imaging elements is configured to image light of a respective color. The light sensor includes regions of sensor elements disposed opposite respective ones of the imaging elements. The sensor elements in each of the regions are operable to generate a component of the color image signal in response to the light of the respective color incident on them.
EP 2 451 150 A2 discloses a system for calibrating a color sensing pixel based upon the distance between the color sensing pixel and an object. The distance is determined by measuring the phase shift of electromagnetic radiation as reflected from the surface of the object compared with the wave profile of the electromagnetic radiation incident on the object surface. The color sensing pixel is associated with a Time-of-Flight (ToF) pixel which is employed to determine the distance of the color sensing pixel. The electromagnetic radiation can be from any part of the electromagnetic spectrum, in particular the infrared and visible light portions of the electromagnetic spectrum. The color sensing pixel and the ToF pixel can reside on the same semiconductor or on disparate semiconductors.

### SUMMARY

The solution is specified by an imaging device for capturing images of a scene as claimed in claim 1. Dependent claims specify embodiments thereof.

### BRIEF DESCRIPTION OF THE DRAWINGS

Apparatuses of and techniques using an asymmetric sensor array for capturing images are described with reference to the following drawings. The same numbers are used throughout the drawings to reference like features and components:
Figure 1 illustrates an example environment in which an asymmetric sensor array for capturing images can be enabled.
Figure 2 illustrates an example of an asymmetric sensor array of figure 1, shown in both cross-section and plan views.
Figure 3 illustrates alternative asymmetric sensor arrays, all shown in plan view.
Figure 4 illustrates lens stacks of different Z-heights relative to sensor sizes of sensors in an asymmetric sensor array.
Figure 5 illustrates the imaging device of figure 1 in greater detail.
Figure 6 illustrates example methods that use an asymmetric sensor array to capture images and, with those images, create a final image.
Figure 7 illustrates various components of an electronic device that can implement an asymmetric sensor array for capturing images in accordance with one or more embodiments.

### DETAILED DESCRIPTION

Conventional sensor arrays use an array of equivalent image sensors to realize a final image. These sensor arrays enable a camera to have a low Z-height relative to the quality of the final image. Compared to a single sensor that provides a similar image quality, for example, sensor arrays have a low Z-height. This is due to a relationship between sensor size and Z height for the lens that focuses the image onto the sensor. Thus, a four-megapixel single sensor requires, assuming similar lens characteristics, a much taller Z height than an array of four one-megapixel sensors. Each of the four one-megapixel sensors is smaller and thus uses a shorter Z-height.

These conventional sensor arrays, however, have various limitations, such as failing to realize sharp optics, depth of color, scene-independent image reconstruction, or low-light sensitivity.

Consider, for example, a conventional sensor having a 2 x 2 grid of sensors, the sensors having red, green, green, and blue pixels to capture images. Each of the four sensors in the array includes small repeating squares having four pixels each, one pixel that senses red, one blue, and two green. The two green are used to determine resolution (e.g., sharpness) in addition to the color green. Mathematically, a one-megapixel sensor is then capable of one-half-megapixel resolution. Through various computational processes, which are not the topic of this disclosure, this one-half-megapixel resolution can be interpolated to improve the resolution (again, with varied success) by about 20%. Thus, the one-megapixel red, green, green, blue sensor can result in a final resolution of about 0.7 megapixels, though this final resolution has limitations as noted above.

To maximize this resolution, conventional sensor arrays use small color pixels to increases a number of pixels in a sensor, and thus keep the size of the sensor down, which in turn keeps the Z-height relatively low. Small color pixels, however, often fail to handle noise well, as each pixel's ability is limited by size, and thus small pixels have poorer signal-to-noise ratios than large pixels. Conventional sensor arrays often forgo use of large pixels, however, because doing so increases the Z-height or reduces the final resolution of the image.

Consider instead, however, an example asymmetric sensor array for capturing images. This asymmetric sensor array, instead of using small color pixels and equivalent sensors, uses an asymmetric sensor array having a central monochrome sensor for resolution and peripheral, relatively large color-pixel sensors for color. The central monochrome-pixel sensor provides high resolution using small pixels. The peripheral, large-pixel color sensors provide color and, due to their size, have excellent signal-to-noise ratios, and thus provide truer color, better color in low-light situations, or other benefits described below. While these peripheral color sensors have lower resolution than the central sensor, the human eye distinguishes less detail in color than it does in greyscale (*e.g.,* the image's resolution or sharpness). Therefore, this asymmetric sensor array provides a final image that conforms to the human eye's characteristics - with high sharpness and truer color, as well as less sensitively to low-light and other adverse scene characteristics.

The following discussion first describes an operating environment, then example asymmetric sensor arrays, then a detailed description of an example imaging device, followed by techniques that may be employed in this environment and imaging device, and ends with an example electronic device.

### Example Environment

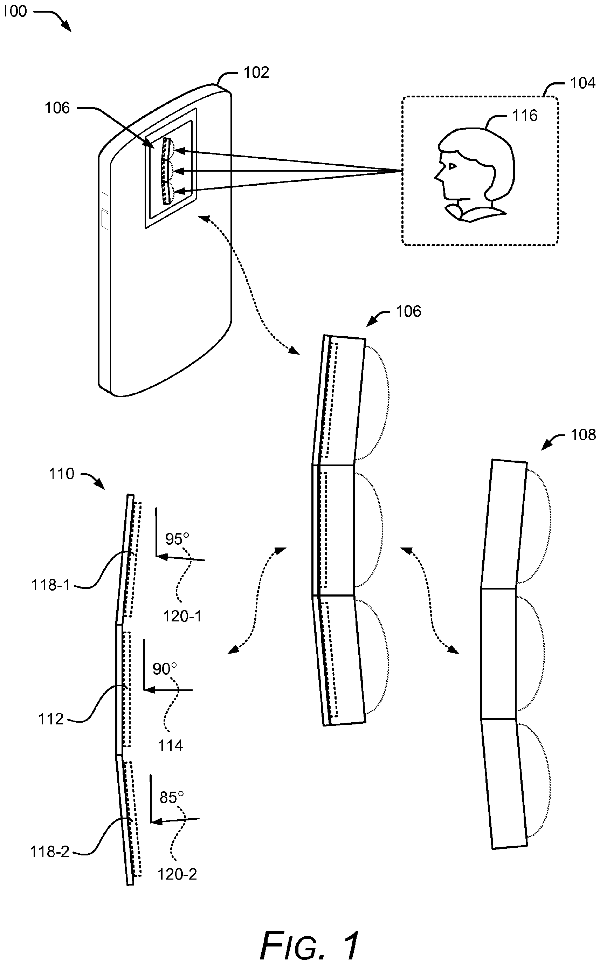

Figure 1 illustrates an example environment 100 in which an asymmetric sensor array for capturing images can be embodied. Example environment 100 includes an imaging device 102 capturing images of a scene 104. Imaging device 102 includes an imager 106, which includes lens stacks 108 and asymmetric sensor array 110, shown combined and separate.

Asymmetric sensor array 110 includes a main sensor 112 having a main resolution and angled at a main angle 114. Here main angle 114, as shown relative to object 116 of scene 104, is at ninety degrees. Asymmetric sensor array 110 also includes multiple peripheral sensors 118. These peripheral sensors 118 have peripheral resolutions or colors that are asymmetric to the main colors or resolution. Asymmetric sensors can be asymmetric to each other by having different numbers of pixels, color-sensing of pixels, sizes of pixels, or sensor size.

Peripheral sensors 118 (shown at 118-1 and 118-2) can be positioned at peripheral angles 120 (shown as peripheral angles 120-1 and 120-2, respectively), which are different from main angle 114 of main sensor 112. This difference or differences in angles enables a depth of image to be created for an image of a scene based on peripheral data sensed by the one of the peripheral sensors of the scene and main data sensed by the main sensor of the same scene or different peripheral data sensed by a different peripheral sensor of the same scene, or some combination of these. Thus, peripheral angle 120-1 of 5° off of main angle 114 captures peripheral data through capture of an image of object 116 different from that of an image captured of object 116 from main sensor 112 at main angle 114.

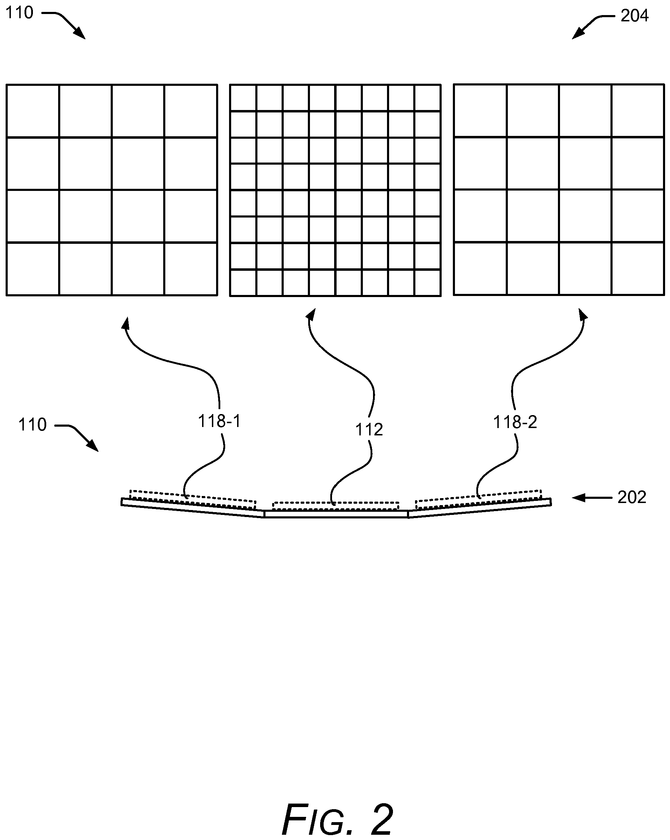

Consider figure 2, which illustrates an example of asymmetric sensor array 110 of figure 1. In figure 1, asymmetric sensor array 110 is shown oriented vertically and in cross section and is also shown at cross-section view 202 in figure 2 but oriented horizontally. Figure 2 illustrates, expanded and in a plan view 204, asymmetric sensor array 110. Note that asymmetric sensor array 110 is structured such that main sensor 112 is centered between peripheral sensors 118.

As mentioned above, main sensor 112 may include various resolutions and types. In the example of figure 2, main sensor 112 is monochrome with a clear color filter. This monochrome aspect improves signal-to-noise ratio in low-light situations and, as noted, enables a high detail for a given pixel count, though in monochrome (e.g., grayscale). Thus, main sensor 112 enables higher detail than color-pixel sensors. Main sensor 112 can also perform better in low-light environments due to an improved signal-to-noise ratio (SNR). In some cases, main sensor 112 also includes a filter permitting infrared radiation to be sensed by main sensor 112. Typically infrared radiation is not desired for color-pixel sensors because infrared radiation inhibits color fidelity. Here, however, main sensor 112 is monochrome, and thus this typical limitation is not present. Further, by permitting infrared radiation to be sensed, the bandwidth captured by the imager is expanded into the near Infrared (IR). This also improve SNR in low-light scenes, in some cases so much that main sensor 112 may capture images in near darkness. IR sensing may, in some cases, permit a faster exposure time as well as better capture of moving objects in a scene, which can be useful for still images and for capture of multiple images in recording a video, especially for high-resolution capture of video.

This illustration shows resolutions of main sensor 112 and peripheral sensors 118 in terms of a number and size of squares, which are here assumed to be pixels. While simplified for visual clarity (showing millions of pixels is not possible for this type of illustration), main sensor 112 includes four times the number of pixels of each of peripheral sensors 118, and peripheral sensors 118 include pixels that are four times as large as those of main sensor 112.

The estimation of a depth map for images *(e.g.,* a per-pixel estimation of the distance between a camera and a scene) improves with image SNR. Given this, and the use of peripheral sensors 118 at some angle relative to main sensor 112 for depth mapping, the larger size of pixels of peripheral sensors 118 can improve depth mapping by improving SNR. In more detail, smaller pixels have less capacity to absorb photons, and thus, they have less capacity to accept noise. Therefore, the larger pixels allow for a better signal-to-noise ratio, which aids in depth mapping for accurate color representation and for low-light scenes.

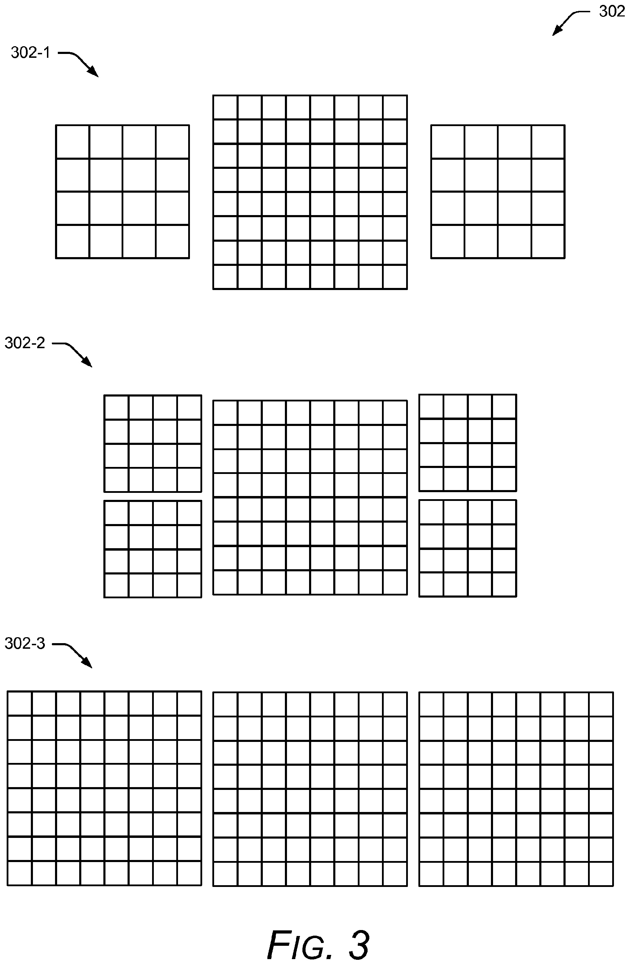

In addition to the example shown in figure 2, consider figure 3, which illustrates alternative asymmetric sensor arrays 302, all shown in plan view. Asymmetric sensor array 302-1 includes a clear, high pixel-count main sensor and two color-pixel peripheral sensors with larger pixels but smaller overall physical size than that of the main sensor. Asymmetric sensor array 302-2 includes a clear, high pixel-count main sensor and four peripheral color-pixel sensors with same-size pixels as that of the main sensor. Asymmetric sensor array 302-3 includes a clear or a color high-pixel count main sensor and two large-sized and high-pixel count peripheral sensors with color pixels. The color sensors may be Bayer filter sensors, panchromatic cell sensors, improved or angled Bayer-type filter sensors (e.g., EXR and X-Trans by Fujifilm™), or other color-capturing sensors. The color sensors may sense a wide variety of colors and be structured with color pixels, such as red, green, green, and blue pixels arranged in squares, red, green, blue, and white also in squares, angled double-pixel colored (non-square) of cyan, magenta, and yellow or red, green, and blue of roughly equal amounts (rather than more green), and so forth.

Each of these asymmetric sensor arrays 302 and 110 are examples, rather than limitations to the types of asymmetric sensor arrays contemplated by this disclosure. This description now turns to lens stacks 108.

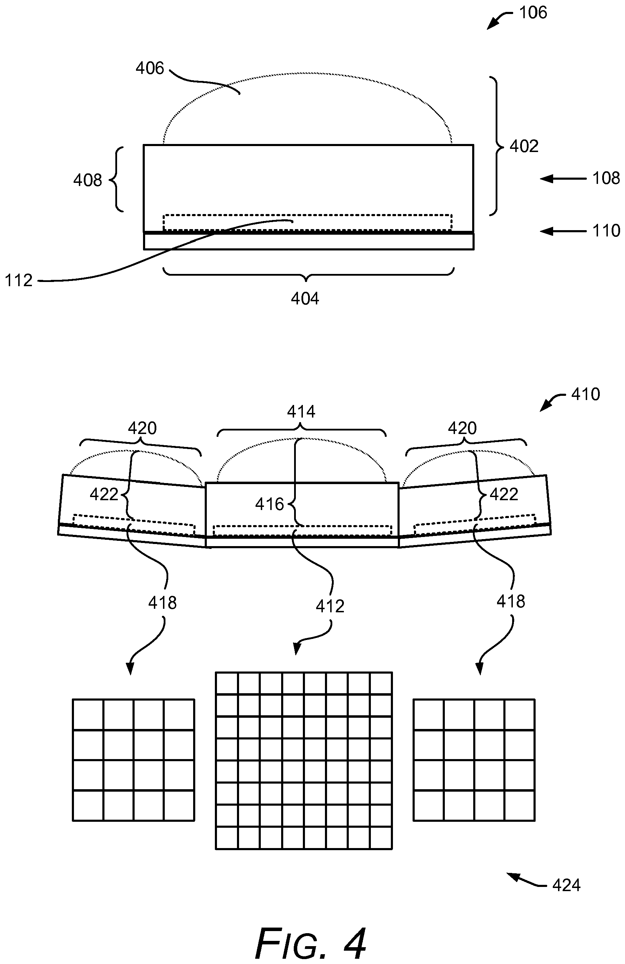

As noted for figure 1, imaging device 102 includes imager 106, which includes asymmetric sensor array 110 and lens stacks 108. Figure 4 illustrates one of lens stacks 108 in detail to describe a relationship between sensor size and Z-height mentioned above. As shown, and assuming a similar lens material and physical structure, Z-height 402 is related (in some cases proportional) to dimensions of sensors, such as X-width 404 of main sensor 112. As shown, a height of lens 406, along with some distance to focus light (focal distance 408) makes up Z-height 402, which together are related to X-width 404 (as well as Y-breadth, not shown).

Figure 4 also illustrates an example asymmetric sensor array 410 with a main sensor 412 having an X-width 414 related to a lens-stack height 416 and two peripheral sensors 418 having a smaller X-width 420 related to a smaller lens-stack height 422. This illustration shows that a Z-height of an imager is related to sensor size (Y-breadth is illustrated and equal to respective X-widths). A plan view 424 of asymmetric sensor array 410 is also provided to show this relationship. While not required, in some cases main and peripheral sensors (e.g., main sensor 412 and peripheral sensors 418) and integrated into a single die or substrate. Imager 106 may also be structured as an integrated apparatus, such as including asymmetric sensor array 410 along with lens stacks for each of the sensors in the array.

While not shown, the various imagers may include, or imaging device 102 may include separate from the various imagers, an auto-focus device capable of determining a focus of the main sensor in part using depth data captured by the peripheral sensors. This is not required, as in some cases no auto-focus is needed. Use of an auto-focus device can depend on a desired image quality and a size and resolution of sensors used to deliver this image quality. This can be balanced, however, with an undesirable focus lag of many current auto-focus mechanisms. The asymmetric sensor array, however, can reduce this focus lag by decreasing an iterative adjust and sense operation of current auto-focus systems. The iterative adjust and sense operation is decreased by using depth information captured by the peripheral sensors to guide the auto-focus system, thereby reducing a number of iterations required to achieve focus.

Furthermore, these various imagers can be structured to be capable of focusing at objects in scenes beyond about two meters from the lens of the main sensor without a focusing mechanism. If focusing on objects within two meters is desired, a simpler optical system to adjust focus only at near-field scenes (objects within one to two meters) can be used. This simpler optical system can be a near-far toggle, for example.

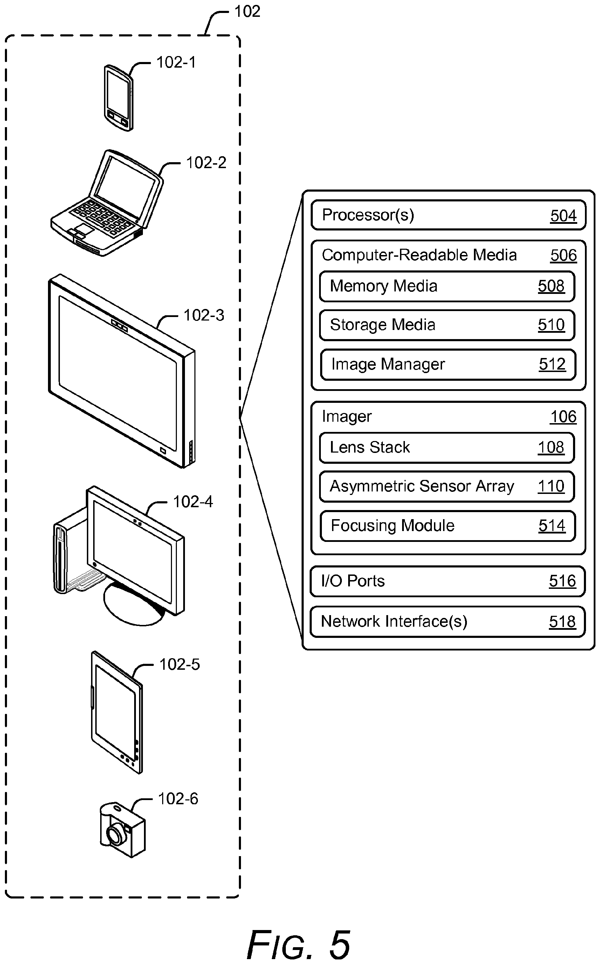

Having generally described asymmetric sensor arrays and imagers, this discussion now turns to figure 5, which illustrates imaging device 102 of figure 1 in greater detail. Imaging device 102 is illustrated with various non-limiting example devices: smartphone 102-1, laptop 102-2, television 102-3, desktop 102-4, tablet 102-5, and camera 102-6. Imaging device 102 includes processor(s) 504 and computer-readable media 506, which includes memory media 508 and storage media 510. Applications and/or an operating system (not shown) embodied as computer-readable instructions on computer-readable memory 506 can be executed by processor(s) 504 to provide some or all of the functionalities described herein. Computer-readable media 506 also includes image manager 512. As noted above, imaging device 102 includes imager 106, which in turn includes lens stacks 108 and asymmetric sensor array 110, and in some cases a focusing module 514, which may be software or hardware or both *(e.g.,* as an above-mentioned auto-focus system).

In some cases, imaging device 102 is in communication with, but may not necessarily include, imager 106 or elements thereof. Captured images are then received by imaging device 102 from imager 106 via the one or more I/O ports 516. I/O ports 516 can include a variety of ports, such as by way of example and not limitation, high-definition multimedia (HDMI), digital video interface (DVI), display port, fiber-optic or light-based, audio ports (*e.g.,* analog, optical, or digital), USB ports, serial advanced technology attachment (SATA) ports, peripheral component interconnect (PCI) express based ports or card slots, serial ports, parallel ports, or other legacy ports. Imaging device 102 may also include network interface(s) 518 for communicating data over wired, wireless, or optical networks. By way of example and not limitation, network interface 518 may communicate data over a local-area-network (LAN), a wireless local-area-network (WLAN), a personal-area-network (PAN), a wide-area-network (WAN), an intranet, the Internet, a peer-to-peer network, point-to-point network, a mesh network, and the like.

### Example Methods

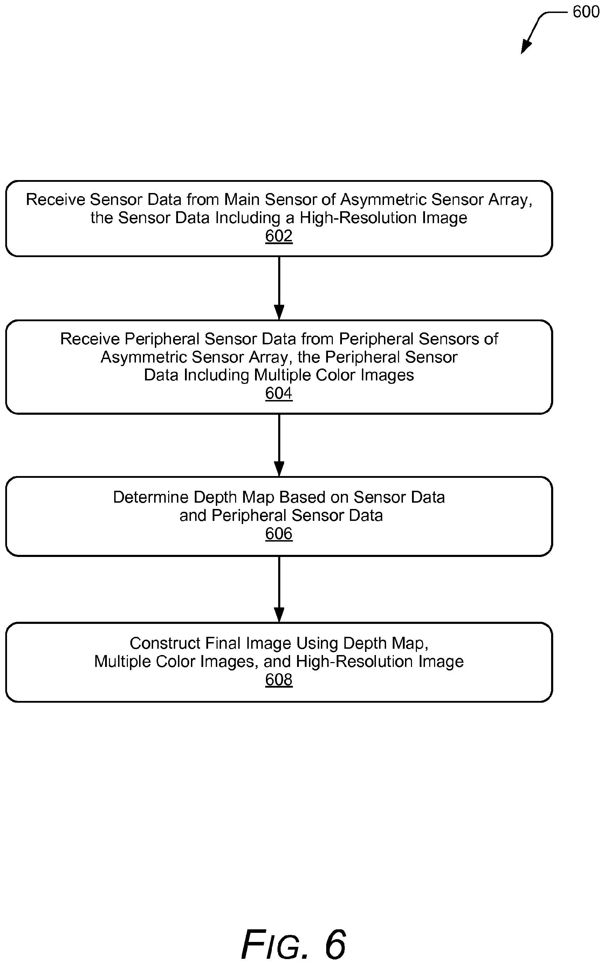

The following discussion describes methods by which techniques are implemented to enable use of asymmetric sensor arrays for capturing images. These methods can be implemented utilizing the previously described environment and example sensor arrays and imagers, such as shown in figures 1-5. Aspects of these example methods are illustrated in figure 6, which are shown as operations performed by one or more entities. The orders in which operations of these methods are shown and/or described are not intended to be construed as a limitation, and any number or combination of the described method operations can be combined in any order to implement a method, or an alternate method.

Figure 6 illustrates example methods 600 using an asymmetric sensor array to capturing images and, with those images, create a final image. At 602, sensor data is received from a main sensor of an asymmetric sensor array. The main sensor, as noted above, may be monochromatic, and thus the sensor data include a high-resolution, monochromatic image of a scene. Using imaging device 102 of figures 1 and 5 as an example, image manager 512 receives, from main sensor 112, sensor data capturing scene 104 and object 116. Assuming also that main sensor 112 and peripheral sensors 118 are as shown in figure 2, main sensor 112 provides sensor data that is monochromatic and high resolution with good data for low-light scenes.

At 604, peripheral sensor data including multiple color images of the scene are received from peripheral sensors. One or more of the multiple color images can be sensed at an angle different than the angle of reception of the sensor data of the main sensor. As noted above, this different angle enables creation of a depth map along with other uses also described above. Also, in some example asymmetric sensor arrays, such as asymmetric sensor array 110, 302-1, and 302-2 (but not 302-3), of figures 2 and 3, respectively, the color images are low resolution relative to the resolution of the main sensor.

Continuing the ongoing example, peripheral sensor data from peripheral sensors 118 include two low-resolution color images of scene 104, both of which are sensed at angles different from those of main sensor 112, namely by five degrees (see figure 1), though other angles may instead be used.

At 606, a depth map is determined based on the multiple color images. This depth map includes information relating to distances of surfaces in a sense (such as object 116 of scene 104 of figure 1), though these distances may be relative to a focal plane, other objects in the scene, or the imager or sensors. Here image manager 512 of figure 5 receives the sensor data from main sensor 112 and peripheral sensor data from peripheral sensors 118. Image manager 512 then determines the depth map based on the color images being sensed at different angles from the main sensor's high-resolution image (whether color or monochrome).

At 608, a final image is constructed using the depth map, the multiple color images, and the high-resolution image. Image manager 512, for example, may "paint" the low-resolution color images from peripheral sensors 118 onto the high-resolution, monochromatic image from main sensor 112, in part with use of the depth map. By so doing, methods 600 create a final image having object 116 in focus, with high sharpness, accurate color and depth of color, and, in many cases, using fewer computation resources or more quickly (in focusing or processing).

### Example Electronic Device

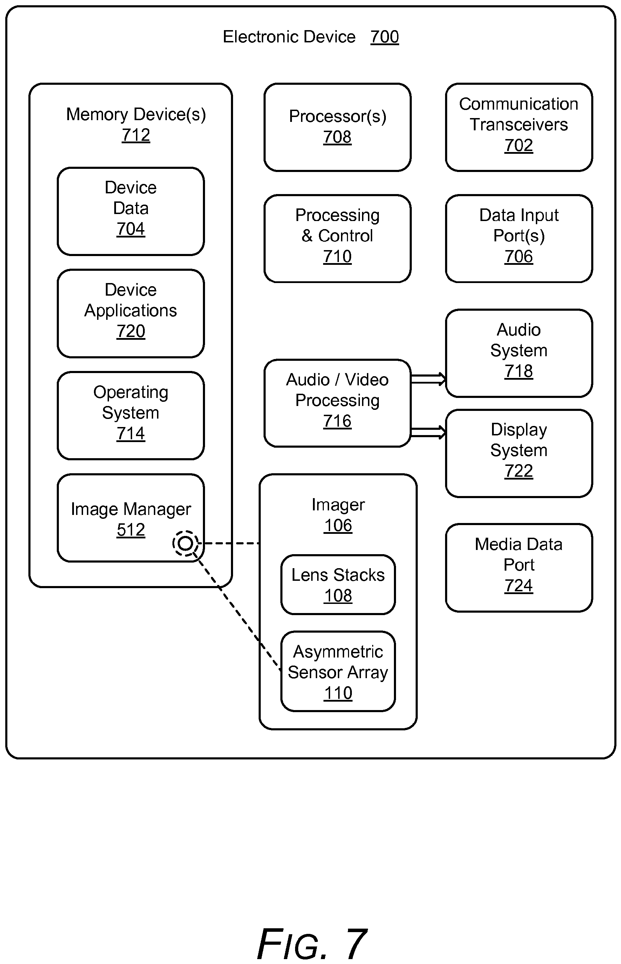

Figure 7 illustrates various components of an example electronic device 700 that can be implemented as an imaging device as described with reference to any of the previous figures 1-6. The electronic device may be implemented as any one or combination of a fixed or mobile device, in any form of a consumer, computer, portable, user, communication, phone, navigation, gaming, audio, camera, messaging, media playback, and/or other type of electronic device, such as imaging device 102 described with reference to figures 1 and 5.

Electronic device 700 includes communication transceivers 702 that enable wired and/or wireless communication of device data 704, such as received data, transmitted data, or sensor data as described above. Example communication transceivers include NFC transceivers, WPAN radios compliant with various IEEE 802.15 (Bluetooth™) standards, WLAN radios compliant with any of the various IEEE 802.11 (WiFi™) standards, WWAN (3GPP-compliant) radios for cellular telephony, wireless metropolitan area network (WMAN) radios compliant with various IEEE 802.16 (WiMAX™) standards, and wired local area network (LAN) Ethernet transceivers.

Electronic device 700 may also include one or more data input ports 706 via which any type of data, media content, and/or inputs can be received, such as user-selectable inputs, messages, music, television content, recorded video content, and any other type of audio, video, and/or image data received from any content and/or data source (*e.g.,* other image devices or imagers). Data input ports 706 may include USB ports, coaxial cable ports, and other serial or parallel connectors (including internal connectors) for flash memory, DVDs, CDs, and the like. These data input ports may be used to couple the electronic device to components (e.g., imager 106), peripherals, or accessories such as keyboards, microphones, or cameras.

Electronic device 700 of this example includes processor system 708 (*e.g.,* any of application processors, microprocessors, digital-signal-processors, controllers, and the like), or a processor and memory system (*e.g*., implemented in a SoC), which process (*i.e.,* execute) computer-executable instructions to control operation of the device. Processor system 708 (processor(s) 708) may be implemented as an application processor, embedded controller, microcontroller, and the like. A processing system may be implemented at least partially in hardware, which can include components of an integrated circuit or on-chip system, digital-signal processor (DSP), application-specific integrated circuit (ASIC), field-programmable gate array (FPGA), a complex programmable logic device (CPLD), and other implementations in silicon and/or other hardware.

Alternatively or in addition, electronic device 700 can be implemented with any one or combination of software, hardware, firmware, or fixed logic circuitry that is implemented in connection with processing and control circuits, which are generally identified at 710 (processing and control 710). Hardware-only devices in which an asymmetric sensor array for capturing images may be embodied include those that convert, without computer processors, sensor data into voltage signals by which to control focusing systems (*e.g*., focusing module 514).

Although not shown, electronic device 700 can include a system bus, crossbar, or data transfer system that couples the various components within the device. A system bus can include any one or combination of different bus structures, such as a memory bus or memory controller, a peripheral bus, a universal serial bus, and/or a processor or local bus that utilizes any of a variety of bus architectures.

Electronic device 700 also includes one or more memory devices 712 that enable data storage, examples of which include random access memory (RAM), non-volatile memory (*e.g*., read-only memory (ROM), flash memory, EPROM, EEPROM, etc.), and a disk storage device. Memory device(s) 712 provide data storage mechanisms to store the device data 704, other types of information and/or data, and various device applications 720 (*e.g.,* software applications). For example, operating system 714 can be maintained as software instructions within memory device 712 and executed by processors 708. In some aspects, image manager 512 is embodied in memory devices 712 of electronic device 700 as executable instructions or code. Although represented as a software implementation, image manager 512 may be implemented as any form of a control application, software application, signal-processing and control module, or hardware or firmware installed on imager 106.

Electronic device 700 also includes audio and/or video processing system 716 that processes audio data and/or passes through the audio and video data to audio system 718 and/or to display system 722 (*e.g.,* a screen of a smart phone or camera). Audio system 718 and/or display system 722 may include any devices that process, display, and/or otherwise render audio, video, display, and/or image data. Display data and audio signals can be communicated to an audio component and/or to a display component via an RF (radio frequency) link, S-video link, HDMI (high-definition multimedia interface), composite video link, component video link, DVI (digital video interface), analog audio connection, or other similar communication link, such as media data port 724. In some implementations, audio system 718 and/or display system 722 are external components to electronic device 700. Alternatively or additionally, display system 722 can be an integrated component of the example electronic device, such as part of an integrated touch interface. Electronic device 700 includes, or has access to, imager 106, which includes lens stacks 108 and asymmetric sensor array 110 (or 302 or 410). Sensor data is received from imager 106 and/or asymmetric sensor array 110 by image manager 512, here shown stored in memory devices 712, which when executed by processor 708 constructs a final image as noted above.

Although embodiment of an asymmetric sensor array for capturing images have been described in language specific to features and/or methods, the subject of the appended claims is not necessarily limited to the specific features or methods described. Rather, the specific features and methods are disclosed as example implementations an asymmetric sensor array for capturing images.

## Claims

1. An imaging device for capturing images of a scene (104) comprising:
an imager (106), the imager (106) comprising:
an asymmetric sensor array (110, 410) having within a single die or substrate a main sensor (112, 412) and two or more peripheral sensors (118, 418), wherein the main sensor (112, 412) has a main resolution and is angled at a main angle (114) relative to an object (116) of the scene (104) and the two or more peripheral sensors (118, 418) have peripheral resolutions being asymmetric to the main resolution by having at least one of a different number of pixels, different color-sensing of pixels, different size of pixels or different sensor size and are positioned at peripheral angles (120) relative to the object (116) of the scene (104) different from the main angle (114) of the main sensor (112, 412); and
a lens stack (108) for each of the main and peripheral sensors (112, 412, 118, 418);
one or more computer processors (504, 408); and
one or more computer-readable storage media (506) having instructions stored thereon that, responsive to execution by the one or more computer processors (504), implements an image manager capable of performing operations comprising:
receiving, from the main sensor (112, 412), sensor data, the sensor data including a high-resolution, monochromatic image of a scene (104);
receiving, from the peripheral sensors (118, 418), peripheral sensor data, the peripheral sensor data including multiple low-resolution color images of the scene (104), at least one of the multiple low-resolution color images being sensed at an angle different than an angle of reception of the sensor data of the main sensor (112, 412);
determining, based on at least one of the multiple low-resolution color images of the scene (104) being sensed at different angles from the main sensor and on the monochromatic high-resolution image of the same scene (104), being sensed by the main sensor, a depth map; and
constructing a final image using the low-resolution color images, the depth map, and the monochromatic high-resolution image.

2. The imaging device as recited in claim 1, wherein the main resolution is a first number of pixels and the peripheral resolutions are each a second number of pixels, the first number of pixels being larger than the second number of pixels.

3. The imaging device as recited in claim 1, wherein the main sensor (112, 412) includes a first size of pixels and the peripheral sensors (118, 418) include a second size of pixels, the first size smaller than the second size.

4. The imaging device as recited in claim 1, wherein the main sensor (112, 412) is a monochrome with a clear color filter.

5. The imaging device as recited in claim 1, wherein the main sensor (112, 412) includes a filter permitting infrared radiation to be sensed by the main sensor (112, 412).

6. The imaging device as recited in claim 1, wherein the main sensor (112, 412) is centered between the peripheral sensors (118, 418).

7. The imaging device as recited in claim 6, wherein the peripheral sensors (118, 418) include two or four peripheral sensors (118, 418).

8. The imaging device as recited in claim 1, wherein the peripheral sensors (118, 418) are Bayer sensors.

9. The imaging device of claim 1, wherein the final image includes a high-resolution of the high-resolution, monochromatic image and colors of the multiple low-resolution color images, and/or
wherein pixels of the peripheral sensors (118, 418) are larger than pixels of the main sensor (112, 412), and/or
wherein the imaging device (102) is capable of constructing, without a focusing mechanism, the final image in focus for objects of a scene (104) that are beyond two meters from the imager.

10. The imaging device of claim 1, further comprising a near-far toggle focus system.

## Patentansprüche

1. Bildgebungsvorrichtung zum Aufnehmen von Bildern einer Szene (104), aufweisend:
einen Bildgeber (106), wobei der Bildgeber (106) Folgendes aufweist:
eine asymmetrische Sensoranordnung (110, 410), aufweisend einen Hauptsensor (112, 412) innerhalb eines einzelnen Chips oder eines Substrats und zwei oder mehrere periphere Sensoren (118, 418), wobei der Hauptsensor (112, 412) eine Hauptauflösung aufweist und im Hauptwinkel (114) relativ zu einem Objekt (116) der Szene (104) abgewinkelt ist und die zwei oder mehreren peripheren Sensoren (118, 418) mit peripheren Auflösungen, die asymmetrisch zur Hauptauflösung sind, indem diese zumindest eine unterschiedliche Anzahl an Pixeln, eine unterschiedliche Farbabtastung von Pixeln, eine unterschiedliche Größe an Pixeln oder eine unterschiedliche Sensorgröße aufweisen, und in peripheren Winkeln (120) relativ zum Objekt (116) der Szene (104), die sich vom Hauptwinkel (114) des Hauptsensors (112, 412) unterscheiden, positioniert sind; und
einen Linsenstapel (108) für jeden der Haupt- und peripheren Sensoren (112, 412, 118, 418);
einen oder mehrere Rechnerprozessoren (504, 408); und
ein oder mehrere rechnerlesbare Speichermedien (506) mit darauf gespeicherten Anweisungen, die als Reaktion auf die Ausführung durch den einen oder die mehreren Rechnerprozessoren (504) einen Bildgebungsmanager implementieren, der in der Lage ist, Vorgänge auszuführen, die Vorgänge umfassen:
ein Empfangen von Sensordaten vom Hauptsensor (112, 412), wobei die Sensordaten ein hochauflösendes, monochromatisches Bild einer Szene (104) beinhalten;
ein Empfangen von peripheren Sensordaten von den peripheren Sensoren (118, 418), wobei die peripheren Sensordaten mehrere Farbbilder mit niedriger Auflösung der Szene (104) beinhalten, wobei zumindest eines der mehreren Farbbilder mit niedriger Auflösung mit einem von dem Empfangswinkel der Sensordaten des Hauptsensors (112, 412) abweichenden Winkel erfasst wird;
ein Ermitteln einer Tiefenkarte, basierend auf zumindest einem der mehreren Farbbildern der Szene (104) mit niedriger Auflösung, die bei von dem Hauptsensor abweichenden Winkeln erfasst werden, und auf dem monochromatischen Bild der Szene (104) mit hoher Auflösung, erfasst vom Hauptsensor; und
ein Aufbauen eines endgültigen Bildes unter Nutzung der Farbbilder mit niedriger Auflösung, der Tiefenkarte und des monochromatischen Bildes mit hoher Auflösung.

2. Bildgebungsvorrichtung nach Anspruch 1, wobei die Hauptauflösung eine erste Anzahl an Pixeln aufweist und die peripheren Auflösungen jeweils eine zweite Anzahl an Pixeln aufweisen, wobei erste Anzahl an Pixeln größer als zweite Anzahl an Pixeln ist.

3. Bildgebungsvorrichtung nach Anspruch 1, wobei der Hauptsensor (112, 412) eine erste Größe an Pixeln aufweist und die peripheren Sensoren (118, 418) eine zweite Größe an Pixeln aufweisen, wobei die erste Größe kleiner als die zweite Größe ist.

4. Bildgebungsvorrichtung nach Anspruch 1, wobei der Hauptsensor (112, 412) monochrom mit einem klaren Farbfilter ist.

5. Bildgebungsvorrichtung nach Anspruch 1, wobei der Hauptsensor (112, 412) einen Filter aufweist, der es erlaubt, Infrarotstrahlung durch den Hauptsensor (112, 412) zu erfassen.

6. Bildgebungsvorrichtung nach Anspruch 1, wobei der Hauptsensor (112, 412) zwischen den peripheren Sensoren (118, 418) zentriert ist.

7. Bildgebungsvorrichtung nach Anspruch 6, wobei die peripheren Sensoren (118, 418) zwei oder vier periphere Sensoren (118, 418) umfassen.

8. Bildgebungsvorrichtung nach Anspruch 1, wobei die peripheren Sensoren (118, 418) Bayer-Sensoren sind.

9. Bildgebungsvorrichtung nach Anspruch 1, wobei das endgültige Bild eine hohe Auflösung des hochauflösenden, monochromatischen Bildes und Farben der mehreren Farbbilder mit niedriger Auflösung beinhaltet, und/oder
wobei Pixel der peripheren Sensoren (118, 418) größer als Pixel des Hauptsensors (112, 412) sind, und/oder
wobei die Bildgebungsvorrichtung (102) in der Lage ist, das endgültige Bild ohne einen Fokussierungsmechanismus im Fokus für Objekte einer Szene (104), die mehr als zwei Meter von dem Bildgeber entfernt sind, aufzubauen.

10. Bildgebungsvorrichtung nach Anspruch 1, ferner umfassend ein Fokussierungssystem mit Nah-Fern-Umschaltung.

## Revendications

1. Dispositif d'imagerie pour la capture d'images d'une scène (104) comprenant :
un imageur (106), l'imageur (106) comprenant :
un réseau de capteurs asymétriques (110, 410) ayant dans une seule matrice ou dans un substrat un capteur principal (112, 412) et deux capteurs périphériques ou plus (118, 418), dans lequel le capteur principal (112, 412) a une résolution principale et est incliné selon un angle principal (114) par rapport à un objet (116) de la scène (104) et les deux capteurs périphériques ou plus (118, 418) ont des résolutions périphériques étant asymétriques par rapport à la résolution principale en ayant au moins un d'un nombre de pixels différent, d'une détection de couleur différente de pixels, d'une taille différente de pixels ou d'une taille de capteur différente et sont positionnés à des angles périphériques (120) par rapport à l'objet (116) de la scène (104) différents de l'angle principal (114) du capteur principal (112, 412) ; et
une pile de lentilles (108) pour chacun des capteurs principaux et périphériques (112, 412, 118, 418) ;
un ou plusieurs processeurs informatiques (504, 408)) ; et
un ou plusieurs supports de stockage lisibles par ordinateur (506) ayant des instructions qui y sont stockées, en réponse à l'exécution par le ou les processeurs informatiques (504), implantent un gestionnaire d'images capable de l'exécution d'opérations comprenant :
la réception, à partir du capteur principal (112, 412), de données de capteur, les données de capteur comprenant une image monochrome de haute résolution d'une scène (104) ;
la réception, à partir des capteurs périphériques (118, 418), des données du capteur périphérique, les données du capteur périphérique comprenant plusieurs images couleur de basse résolution de la scène (104), au moins une des plusieurs images couleur de basse résolution étant détectée à un angle différent d'un angle de réception des données de capteur du capteur principal (112, 412) ;
la détermination, sur base d'au moins une des plusieurs images couleur de basse résolution de la scène (104) étant détectée à différents angles à partir du capteur principal et de l'image monochrome de haute résolution de la scène (104), étant détectée par le capteur principal, d'une carte de profondeur ; et
la construction d'une image finale à l'aide des images couleur de basse résolution, de la carte de profondeur et de l'image monochrome de haute résolution.

2. Dispositif d'imagerie selon la revendication 1, dans lequel la résolution principale est un premier nombre de pixels et les résolutions périphériques sont chacun d'un deuxième nombre de pixels, le premier nombre de pixels étant plus grand que le deuxième nombre de pixels.

3. Dispositif d'imagerie selon la revendication 1, dans lequel le capteur principal (112, 412) comprend une première taille de pixels et les capteurs périphériques (118, 418) comprennent une deuxième taille de pixels, la première taille étant inférieure à la deuxième taille.

4. Dispositif d'imagerie selon la revendication 1, dans lequel le capteur principal (112, 412) est un monochrome avec un filtre couleur transparent.

5. Dispositif d'imagerie selon la revendication 1, dans lequel le capteur principal (112, 412) comprend un filtre permettant la détection du rayonnement infrarouge par le capteur principal (112, 412) .

6. Dispositif d'imagerie selon la revendication 1, dans lequel le capteur principal (112, 412) est centré entre les capteurs périphériques (118, 418).

7. Dispositif d'imagerie selon la revendication 6, dans lequel les capteurs périphériques (118, 418) comprennent deux ou quatre capteurs périphériques (118, 418).

8. Dispositif d'imagerie selon la revendication 1, dans lequel les capteurs périphériques (118, 418) sont des capteurs Bayer.

9. Dispositif d'imagerie selon la revendication 1, dans lequel l'image finale comprend une haute résolution de la haute résolution, l'image monochrome et les couleurs des plusieurs images couleur de basse résolution, et/ ou
dans lequel les pixels des capteurs périphériques (118, 418) sont plus grands que les pixels du capteur principal (112, 412), et/ ou
dans lequel le dispositif d'imagerie (102) est capable de la construction, sans mécanisme de mise au point, de l'image finale concentrée sur les objets d'une scène (104) qui se trouvent au-delà de deux mètres de l'imageur.

10. Dispositif d'imagerie selon la revendication 1, comprenant en outre un système de mise au point à bascule proche-lointain.
